# EUROPEAN PATENT APPLICATION

(11) **EP 2 264 529 A2**
(43) Date of publication of application: **22.12.2010**
(21) Application number: 10164478.9
(22) Date of filing: 31.05.2010
(51) Int. Cl.: G03F 7/20

(54) **A lithographic apparatus, a method of controlling the apparatus and a method of manufacturing a device using a lithographic apparatus**

(30) Priority: 16.06.2009 US 187496 P; 12.10.2009 US 250692 P
(71) Applicant: ASML Netherlands B.V., 5504 DR Veldhoven (NL)
(72) Inventor: Direcks, Daniel, 6369 HC Simpelveld (NL); Kemper, Nicolaas, 5653 RL Eindhoven (NL); Philips, Danny, 5691 LG Son en Breugel (NL); Riepen, Michel, 5501 CA Veldhoven (NL); Van den Dungen, Clemens, 5658 HE Eindhoven (NL); Schepers, Maikel, 5671 AS Nuenen (NL)
(74) Representative: Corcoran, Gregory Martin Mason

(57) **Abstract**

An immersion lithographic apparatus is disclosed that includes a substrate table configured to support a substrate, a projection system configured to direct a patterned beam of radiation onto a substrate, a liquid handling system configured to supply and confine immersion liquid to a space defined between a projection system and a substrate, or substrate table, or both, and a controller to control speed of motion of the substrate table relative to the liquid handling system during movement of the substrate table through a path under the liquid handling system based on a distance between turns in the path.

## Description

### Field

The present invention relates to a lithographic apparatus, a method of controlling the lithographic apparatus and a method of manufacturing a device using a lithographic apparatus.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

It has been proposed to immerse the substrate in the lithographic projection apparatus in a liquid having a relatively high refractive index, e.g. water, so as to fill a space between the final element of the projection system and the substrate. In an embodiment, the liquid is distilled water, although another liquid can be used. An embodiment of the invention will be described with reference to liquid. However, another fluid may be suitable, particularly a wetting fluid, an incompressible fluid and/or a fluid with higher refractive index than air, desirably a higher refractive index than water. Fluids excluding gases are particularly desirable. The point of this is to enable imaging of smaller features since the exposure radiation will have a shorter wavelength in the liquid. (The effect of the liquid may also be regarded as increasing the effective numerical aperture (NA) of the system and also increasing the depth of focus.) Other immersion liquids have been proposed, including water with solid particles (e.g. quartz) suspended therein, or a liquid with a nano-particle suspension (e.g. particles with a maximum dimension of up to 10 nm). The suspended particles may or may not have a similar or the same refractive index as the liquid in which they are suspended. Other liquids which may be suitable include a hydrocarbon, such as an aromatic, a fluorohydrocarbon, and/or an aqueous solution.

Submersing the substrate or substrate and substrate table in a bath of liquid (see, for example, United States patent no. 4,509,852) means that there is a large body of liquid that must be accelerated during a scanning exposure. This requires additional or more powerful motors and turbulence in the liquid may lead to undesirable and unpredictable effects.

In an immersion apparatus, immersion fluid is handled by a fluid handling system, device structure or apparatus. In an embodiment the fluid handling system may supply immersion fluid and therefore be a fluid supply system. In an embodiment the fluid handling system may at least partly confine immersion fluid and thereby be a fluid confinement system. In an embodiment the fluid handling system may provide a barrier to immersion fluid and thereby be a barrier member, such as a fluid confinement structure. In an embodiment the fluid handling system may create or use a flow of gas, for example to help in controlling the flow and/or the position of the immersion fluid. The flow of gas may form a seal to confine the immersion fluid so the fluid handling structure may be referred to as a seal member; such a seal member may be a fluid confinement structure. In an embodiment, immersion liquid is used as the immersion fluid. In that case the fluid handling system may be a liquid handling system. In reference to the aforementioned description, reference in this paragraph to a feature defined with respect to fluid may be understood to include a feature defined with respect to liquid.

### Summary

In immersion lithography some liquid may be lost from the space onto a substrate being exposed or the substrate table supporting the substrate. The lost liquid may pose a defectivity risk. A droplet of liquid present on the substrate/substrate table which later collides with liquid in the space, for example the meniscus of the liquid, may cause the formation of a volume of gas, such as a bubble within the space. The bubble may interfere with imaging radiation directed towards a target portion of the substrate to affect the imaged pattern on the substrate.

It is desirable, for example, to reduce or eliminate the risk of such imaging defects while increasing throughput.

According to an aspect, there is provided an immersion lithographic apparatus comprising: a projection system configured to direct a patterned beam of radiation onto a substrate; a facing surface comprising a table, or a substrate supported by the table, or both; a liquid handling system configured to supply and confine immersion liquid to a space defined between the projection system and the facing surface; and a controller to control motion of the table relative to the liquid handling system during movement of the table under the liquid handling system, the controller configured to vary the speed of the motion based on a distance between changes in direction of the motion.

According to an aspect, there is provided a method of selecting a path of a table under a liquid handling structure of an immersion lithographic apparatus, the method comprising: determining areas of the table which must pass under the liquid handling structure; determining possible directions of movement of the table under the liquid handling structure; determining a plurality of possible paths between the areas which paths include movement over one or more areas of the table which must pass under the liquid handling structure in one of the possible directions; calculating the total time for each of the plurality of possible paths based on a maximum allowable speed of movement determined based on a distance between changes in direction in the path; and selecting one of the plurality of possible paths based on a comparison of the calculated total times.

According to an aspect, there is provided a method of manufacturing a device using a lithographic apparatus, the method comprising: projecting a patterned beam of radiation from a projection system through a liquid onto a substrate; and moving the substrate relative to the projection system through a path, wherein the speed of motion of the substrate relative to the projection system is varied based on a distance between changes in direction in the path.

According to an aspect, there is provided a method of manufacturing a device using a lithographic apparatus, the method comprising: confining liquid by a confinement structure in a space between a projection system and a facing surface of a table, a substrate supported by the table, or both; projecting a patterned beam of radiation from the projection system through liquid onto the substrate; and moving the facing surface relative to the projection system through a path, wherein the distance between changes in direction in the path is selected at least in part by increasing the speed of motion of the facing surface relative to the projection system towards a subcritical speed of a liquid meniscus of the liquid between the facing surface and the confinement structure.

### Brief Description of the Drawings

Embodiments of the invention will now be described, by way of example only, with reference to the accompanying schematic drawings in which corresponding reference symbols indicate corresponding parts, and in which:

Figure 1 depicts a lithographic apparatus according to an embodiment of the invention;

Figures 2 and 3 depict a liquid supply system for use in a lithographic projection apparatus;

Figure 4 depicts a further liquid supply system for use in a lithographic projection apparatus;

Figure 5 depicts a further liquid supply system for use in a lithographic projection apparatus;

Figure 6 depicts, in plan, a liquid handling structure according to an embodiment of the invention;

Figure 7 depicts, in cross-section, a liquid handling structure according to an embodiment of the invention;

Figure 8 depicts, in cross-section, a liquid handling structure according to an embodiment of the invention after movement of a substrate/substrate table relative to the liquid handling structure for a certain distance;

Figure 9 depicts, in cross-section, a liquid handling structure according to an embodiment of the invention after movement of the substrate/substrate table relative to the liquid handling structure beyond a certain distance;

Figure 10 is a graph showing the maximum movement speed and movement length for a certain liquid handling structure moving in a certain direction;

Figure 11 illustrates, in plan, a path of a substrate table under a liquid handling structure;

Figure 12 illustrates, in plan, a path of a substrate table under a liquid handling structure;

Figure 13 illustrates, in plan, a possible path for a substrate table under a liquid handling structure;

Figure 14 illustrates, in plan, a possible path for a substrate table under a liquid handling structure;

Figure 15 depicts, in plan, a possible path of a substrate table under a liquid handling structure;

Figure 16 depicts, in plan, a possible path of a substrate table under a liquid handling structure;

Figure 17 depicts, in cross-section, a substrate table and liquid handling structure according to an embodiment;

Figure 18 depicts, in plan, a substrate table and measurement table according to an embodiment of the invention; and

Figure 19 depicts, in plan, the relative positions of the openings, edge of the damper and meniscus contact line on the substrate table after movement of a certain distance in one direction.

### Detailed Description

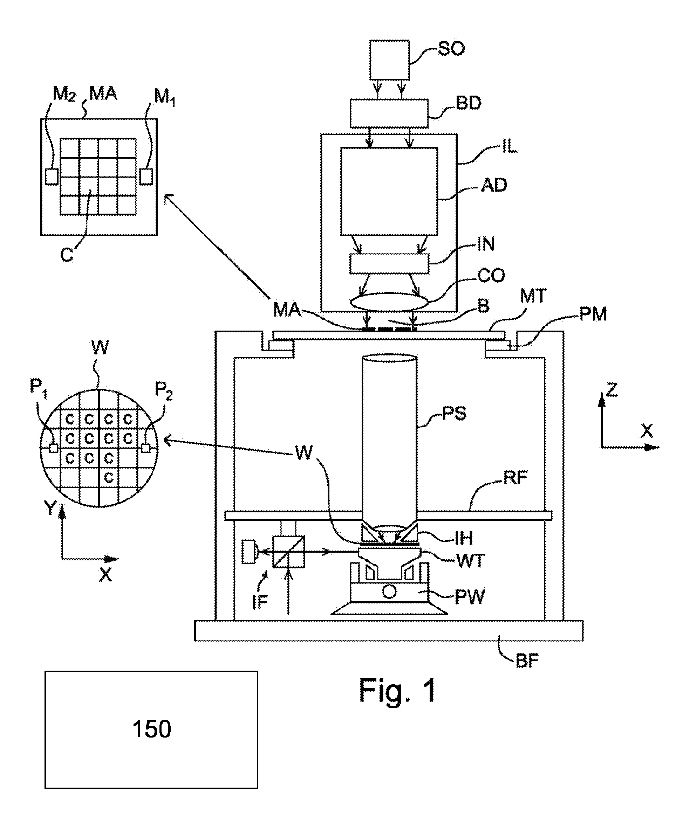

Figure 1 schematically depicts a lithographic apparatus according to one embodiment of the invention. The apparatus comprises:
- an illumination system (illuminator) IL configured to condition a radiation beam B (e.g. UV radiation or DUV radiation);
- a support structure (e.g. a mask table) MT constructed to support a patterning device (e.g. a mask) MA and connected to a first positioner PM configured to accurately position the patterning device MA in accordance with certain parameters;
- a substrate table (e.g. a wafer table) WT constructed to hold a substrate (e.g. a resist-coated wafer) W and connected to a second positioner PW configured to accurately position the substrate W in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system IL may include various types of optical components, such as refractive, reflective, magnetic, electromagnetic, electrostatic or other types of optical components, or any combination thereof, for directing, shaping, or controlling radiation.

The support structure MT holds the patterning device MA. It holds the patterning device MA in a manner that depends on the orientation of the patterning device MA, the design of the lithographic apparatus, and other conditions, such as for example whether or not the patterning device MA is held in a vacuum environment. The support structure MT can use mechanical, vacuum, electrostatic or other clamping techniques to hold the patterning device MA. The support structure MT may be a frame or a table, for example, which may be fixed or movable as required. The support structure MT may ensure that the patterning device MA is at a desired position, for example with respect to the projection system PS. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device MA may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more patterning device tables). In such "multiple stage" machines the additional tables may be used in parallel, or preparatory steps may be carried out on one or more tables while one or more other tables are being used for exposure.

Referring to Figure 1, the illuminator IL receives a radiation beam from a radiation source SO. The source SO and the lithographic apparatus may be separate entities, for example when the source SO is an excimer laser. In such cases, the source SO is not considered to form part of the lithographic apparatus and the radiation beam is passed from the source SO to the illuminator IL with the aid of a beam delivery system BD comprising, for example, suitable directing mirrors and/or a beam expander. In other cases the source SO may be an integral part of the lithographic apparatus, for example when the source SO is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator IL can be adjusted. In addition, the illuminator IL may comprise various other components, such as an integrator IN and a condenser CO. The illuminator IL may be used to condition the radiation beam, to have a desired uniformity and intensity distribution in its cross-section. Similar to the source SO, the illuminator IL may or may not be considered to form part of the lithographic apparatus. For example, the illuminator IL may be an integral part of the lithographic apparatus or may be a separate entity from the lithographic apparatus. In the latter case, the lithographic apparatus may be configured to allow the illuminator IL to be mounted thereon. Optionally, the illuminator IL is detachable and may be separately provided (for example, by the lithographic apparatus manufacturer or another supplier).

The radiation beam B is incident on the patterning device (e.g., mask) MA, which is held on the support structure (e.g., mask table) MT, and is patterned by the patterning device MA. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions C (these are known as scribe-lane alignment marks). Similarly, in situations in which more than one die is provided on the patterning device MA, the patterning device alignment marks may be located between the dies.

The depicted apparatus could be used in at least one of the following modes:

1. In step mode, the support structure MT and the substrate table WT are kept essentially stationary, while an entire pattern imparted to the radiation beam B is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the support structure MT and the substrate table WT are scanned synchronously while a pattern imparted to the radiation beam B is projected onto a target portion C (i.e. a single dynamic exposure). The velocity and direction of the substrate table WT relative to the support structure MT may be determined by the (de-)magnification and image reversal characteristics of the projection system PS. In scan mode, the maximum size of the exposure field limits the width (in the non-scanning direction) of the target portion C in a single dynamic exposure, whereas the length of the scanning motion determines the height (in the scanning direction) of the target portion C.

3. In another mode, the support structure MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

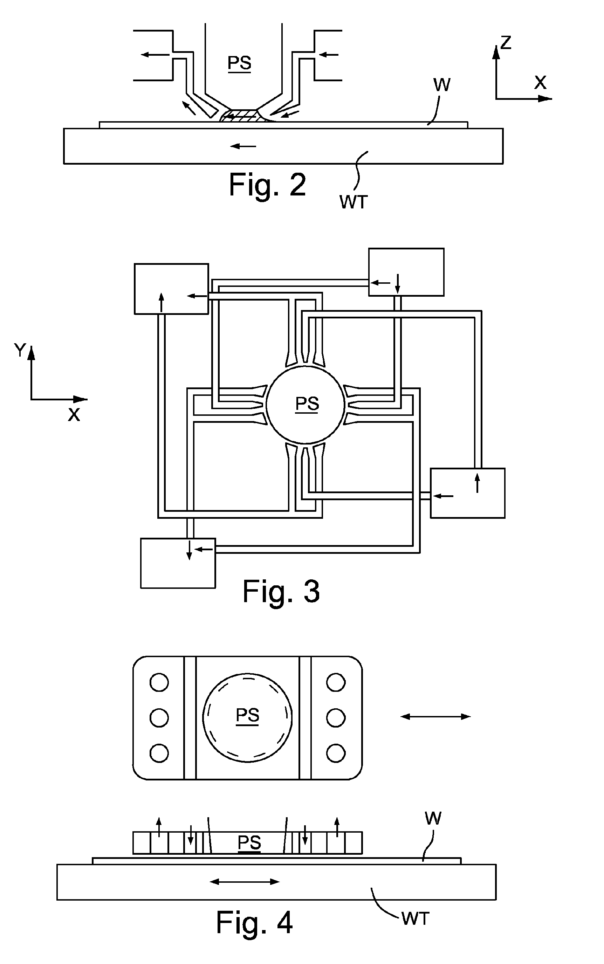

Arrangements for providing liquid between a final element of the projection system and the substrate can be classed into at least two general categories. These are the bath type arrangement and the so called localized immersion system. In the bath type arrangement substantially the whole of the substrate and optionally part of the substrate table is submersed in a bath of liquid. The so called localized immersion system uses a liquid supply system in which liquid is only provided to a localized area of the substrate. In the latter category, the space filled by liquid is smaller in plan than the top surface of the substrate and the area filled with liquid remains substantially stationary relative to the projection system while the substrate moves underneath that area. A further arrangement, to which an embodiment of the invention is directed, is an all wet solution in which the liquid is unconfined. In this arrangement substantially the whole top surface of the substrate and all or part of the substrate table is covered in immersion liquid. The depth of the liquid covering at least the substrate is small. The liquid may be a film, such as a thin film, of liquid on the substrate. Any of the liquid supply devices of Figures 2-5 may be used in such a system; however, sealing features may not be present, may not be activated, may not be as efficient as normal or may be otherwise ineffective to seal liquid to only the localized area. Four different types of localized liquid supply systems are illustrated in Figures 2-5.

One of the arrangements proposed is for a liquid supply system to provide liquid on only a localized area of the substrate and in between the final element of the projection system and the substrate using a liquid confinement system (the substrate generally has a larger surface area than the final element of the projection system). One way which has been proposed to arrange for this is disclosed in PCT Patent Application Publication No. WO 99/49504. As illustrated in Figures 2 and 3, liquid is supplied by at least one inlet onto the substrate, desirably along the direction of movement of the substrate relative to the final element, and is removed by at least one outlet after having passed under the projection system. That is, as the substrate is scanned beneath the element in a -X direction, liquid is supplied at the +X side of the element and taken up at the -X side. Figure 2 shows the arrangement schematically in which liquid is supplied via inlet and is taken up on the other side of the element by outlet which is connected to a low pressure source. The arrows above the substrate W illustrate the direction of liquid flow, and the arrow below the substrate W illustrates the direction of movement of the substrate table. In the illustration of Figure 2 the liquid is supplied along the direction of movement of the substrate relative to the final element, though this does not need to be the case. Various orientations and numbers of in-and out-lets positioned around the final element are possible, one example is illustrated in Figure 3 in which four sets of an inlet with an outlet on either side are provided in a regular pattern around the final element. Arrows in liquid supply and liquid recovery devices indicate the direction of liquid flow.

A further immersion lithography solution with a localized liquid supply system is shown in Figure 4. Liquid is supplied by two groove inlets on either side of the projection system PS and is removed by a plurality of discrete outlets arranged radially outwardly of the inlets. The inlets and outlets can be arranged in a plate with a hole in its center and through which the projection beam is projected. Liquid is supplied by one groove inlet on one side of the projection system PS and removed by a plurality of discrete outlets on the other side of the projection system PS, causing a flow of a thin film of liquid between the projection system PS and the substrate W. The choice of which combination of inlet and outlets to use can depend on the direction of movement of the substrate W (the other combination of inlet and outlets being inactive). In the cross-sectional view of Figure 4, arrows illustrate the direction of liquid flow in inlets and out of outlets.

In European patent application publication no. EP 1420300 and United States patent application publication no. US 2004-0136494, each hereby incorporated in their entirety by reference, the idea of a twin or dual stage immersion lithography apparatus is disclosed. Such an apparatus is provided with two tables for supporting a substrate. Leveling measurements are carried out with a table at a first position, without immersion liquid, and exposure is carried out with a table at a second position, where immersion liquid is present. Alternatively, the apparatus has only one table.

PCT patent application publication WO 2005/064405 discloses an all wet arrangement in which the immersion liquid is unconfined. In such a system the whole top surface of the substrate is covered in liquid. This may be advantageous because then the whole top surface of the substrate is exposed to the substantially same conditions. This has an advantage for temperature control and processing of the substrate. In WO 2005/064405, a liquid supply system provides liquid to the gap between the final element of the projection system and the substrate. That liquid is allowed to leak (or flow) over the remainder of the substrate. A barrier at the edge of a substrate table prevents the liquid from escaping so that it can be removed from the top surface of the substrate table in a controlled way. Although such a system improves temperature control and processing of the substrate, evaporation of the immersion liquid may still occur. One way of helping to alleviate that problem is described in United States patent application publication no. US 2006/0119809. A member is provided which covers the substrate in all positions and which is arranged to have immersion liquid extending between it and the top surface of the substrate and/or substrate table which holds the substrate.

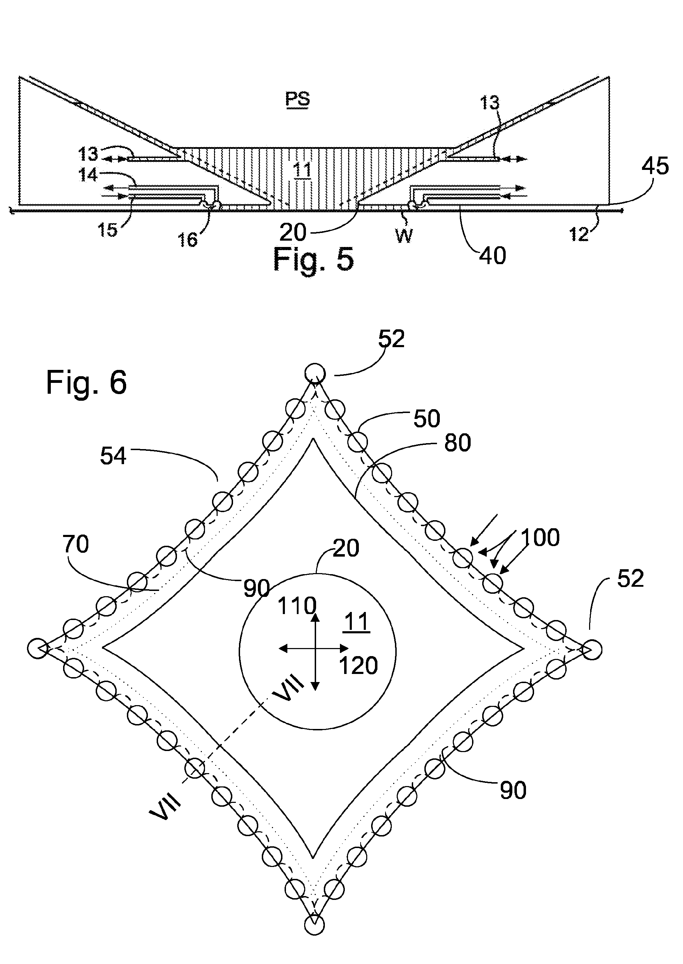

Another arrangement which has been proposed is to provide the liquid supply system with a fluid confinement structure. The fluid confinement structure may extend along at least a part of a boundary of the space between the final element of the projection system and the substrate table. Such an arrangement is illustrated in Figure 5. The fluid confinement structure is substantially stationary relative to the projection system in the XY plane though there may be some relative movement in the Z direction (in the direction of the optical axis). A seal is formed between the fluid confinement structure and the surface of the substrate. In an embodiment, a seal is formed between the fluid confinement structure and the surface of the substrate and may be a contactless seal such as a gas seal. Such a system is disclosed in United States patent application publication no. US 2004-0207824. In another embodiment the fluid confinement structure has a seal which is a non-gaseous seal, and so may be referred to as a liquid confinement structure.

Figure 5 schematically depicts a localized liquid supply system or fluid handling structure or device with a body 12 forming a barrier member or fluid confinement structure, which extends along at least a part of a boundary of the space 11 between the final element of the projection system PS and the substrate table WT or substrate W. (Please note that reference in the following text to surface of the substrate W also refers in addition or in the alternative to a surface of the substrate table WT, unless expressly stated otherwise.) The fluid handling structure is substantially stationary relative to the projection system PS in the XY plane though there may be some relative movement in the Z direction (in the direction of the optical axis). In an embodiment, a seal is formed between the body 12 and the surface of the substrate W and may be a contactless seal such as a gas seal or fluid seal.

The fluid handling device at least partly contains liquid in the space 11 between a final element of the projection system PS and the substrate W. A contactless seal, such as a gas seal 16, to the substrate W may be formed around the image field of the projection system PS so that liquid is confined within the space 11 between the substrate W surface and the final element of the projection system PS. The space 11 is at least partly formed by the body 12 positioned below and surrounding the final element of the projection system PS. Liquid is brought into the space 11 below the projection system PS and within the body 12 by liquid inlet 13. The liquid may be removed by liquid outlet 13. The body 12 may extend a little above the final element of the projection system PS. The liquid level rises above the final element so that a buffer of liquid is provided. In an embodiment, the body 12 has an inner periphery that at the upper end closely conforms to the shape of the projection system PS or the final element thereof and may, e.g., be round. At the bottom, the inner periphery closely conforms to the shape of the image field, e.g., rectangular, though this need not be the case. The inner periphery may be any shape, for example the inner periphery may conform to the shape of the final element of the projection system. The inner periphery may be round.

The liquid is contained in the space 11 by the gas seal 16 which, during use, is formed between the bottom of the body 12 and the surface of the substrate W. The gas seal 16 is formed by gas, e.g. air or synthetic air but, in an embodiment, N₂ or another inert gas. The gas in the gas seal 16 is provided under pressure via inlet 15 to the gap between body 12 and substrate W. The gas is extracted via outlet 14. The overpressure on the gas inlet 15, vacuum level on the outlet 14 and geometry of the gap are arranged so that there is a high-velocity gas flow inwardly that confines the liquid. The force of the gas on the liquid between the body 12 and the substrate W contains the liquid in a space 11. The inlets/outlets may be annular grooves which surround the space 11. The annular grooves may be continuous or discontinuous. The flow of gas is effective to contain the liquid in the space 11. Such a system is disclosed in United States patent application publication no. US 2004-0207824.

The example of Figure 5 is a so called localized area arrangement in which liquid is only provided to a localized area of the top surface of the substrate W at any one time. Other arrangements are possible, including fluid handling systems which make use of a single phase extractor or a two phase extractor as disclosed, for example, in United States patent application publication no US 2006-0038968. In an embodiment, a single or two phase extractor may comprise an inlet which is covered in a porous material. In an embodiment of a single phase extractor the porous material is used to separate liquid from gas to enable single-liquid phase liquid extraction. A chamber downstream of the porous material is maintained at a slight under pressure and is filled with liquid. The under pressure in the chamber is such that the meniscuses formed in the holes of the porous material prevent ambient gas from being drawn into the chamber. However, when the porous surface comes into contact with liquid there is no meniscus to restrict flow and the liquid can flow freely into the chamber. The porous material has a large number of small holes, e.g. of diameter in the range of 5 to 300 µm, desirably 5 to 50 µm. In an embodiment, the porous material is at least slightly liquidphilic (e.g., hydrophilic), i.e. having a contact angle of less than 90° to the immersion liquid, e.g. water.

Many other types of liquid supply system are possible. The invention is not limited to any particular type of liquid supply system. The invention may be advantageous for use with a confined immersion system in which the liquid between the final element of the projection system and the substrate is confined, for example, in optimizing the use. However, the invention can be used with any other type of liquid supply system.

Figure 6 illustrates a meniscus pinning device of an embodiment of the invention which may, for example, replace the seal arrangement 14, 15, 16 of Figure 5. The meniscus pinning device of Figure 6 comprises a plurality of discrete (extraction) openings 50. Each opening 50 is illustrated as being circular though this is not necessarily the case. Indeed the shape of one or more of the openings 50 may be one or more selected from a square, a circle, a rectilinear shape, a rectangle, an oblong, a triangle, an elongate shape such as a slit, etc. Each opening 50 has, in plan, a maximum cross-sectional dimension, such as a diameter, perhaps with a maximum dimension of greater than 0.5 mm, desirably greater than 1 mm. Desirably, the openings 50 are unlikely to be affected much by contamination.

Each of the openings 50 of the meniscus pinning device of Figure 6 may be connected to a separate under pressure source. Alternatively or additionally, each or a plurality of the openings 50 may be connected to a common chamber (which may be annular) which is itself held at an under pressure. In this way a uniform under pressure at each or a plurality of the openings 50 may be achieved. The openings 50 can be connected to a vacuum source and/or the atmosphere surrounding the liquid supply system may be increased in pressure to generate the required underpressure.

Each opening 50 is designed to extract a mixture of liquid and gas, for example in a two phase flow. The liquid is extracted from the space 11 whereas the gas is extracted from the atmosphere on the other side of the openings 50 to the liquid. This creates a gas flow as illustrated by arrows 100. This gas flow is effective to pin the meniscus 90 between the openings 50 substantially in place as illustrated in Figure 6, for example between neighboring openings 50. The gas flow helps maintain the liquid confined by momentum blocking, by a gas flow induced pressure gradient and/or by drag (shear) of the gas flow on the liquid.

As can be seen from Figure 6, the openings 50 are positioned so as to form, in plan, a polygonal shape. In the case of Figure 6 this is in the shape of a rhombus with the principal axes 110, 120 aligned with the major directions of travel of the substrate W under the projection system PS. This helps ensure that the maximum scan speed is faster than if the openings 50 were arranged in a circular shape. This is because the force on the meniscus between two openings 50 is reduced with a factor cos θ, where θ is the angle of the line connecting the two openings 50 relative to the direction in which the substrate W is moving. Thus, throughput can be optimized by having the primary axis 110 of the shape of the openings 50 aligned with the major direction of travel of the substrate (usually the scan direction) and to have a second axis 120 aligned with the other major direction of travel of the substrate (usually the step direction).

It will be appreciated that any arrangement in which θ is different to 90° will give an advantage. Thus, exact alignment of the principal axes with the major directions of travel is not vital. It will further be appreciated that if the shape is circular, then there will always be two openings 50 which are aligned perpendicularly to the direction of travel so that the meniscus between those two outlets receives the maximum available force by movement of the substrate W.

From the above, it can be seen that even the use of a square shape with the sides aligned at about 45° to the principal directions of travel of the substrate gives a great benefit. However, an embodiment of the invention is applicable to any shape made by the openings 50 in plan, for example a circle.

Radially outward of the openings may be a gas knife opening through which a gas flow may be supplied during operation. Such an arrangement is described in United States Patent Application No. US 61/181,158 filed 25 May 2009, which is hereby incorporated by reference in its entirety. In an embodiment there is no gas knife. By avoiding the use of a gas knife, the amount of evaporation of liquid from the substrate W may be reduced thereby reducing splashing of liquid and/or thermal expansion/contraction effects. Avoiding the use of the gas knife may be desirable because the gas flow of a gas knife may apply a downward force onto the substrate. The force may cause the surface of the substrate to deform.

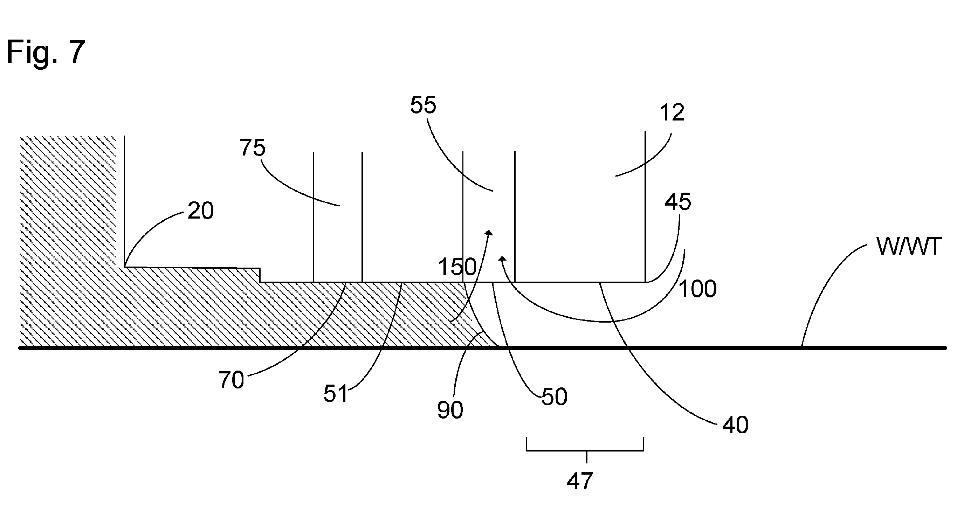

Figure 7 is a cross-section through the liquid handling structure 12 along the line VII-VII shown in Figure 6. In Figure 7 an arrow 100 shows the flow of gas from outside of the liquid handling structure 12 into the passageway 55 associated with the opening 50. The arrow 150 illustrates the passage of liquid from under the liquid handling structure 12, which may have come from the space 11, into the opening 50. The passageway 55 and opening 50 are designed so that two phase extraction (i.e. gas and liquid) desirably occurs in an annular flow mode. In annular flow mode gas may substantially flow through the center of the passageway 55; liquid may substantially flow along the wall(s) of the passageway 55. This results in smooth flow with low generation of pulsations, thereby desirably minimizing the vibrations which may otherwise occur.

The meniscus 90 is pinned between the openings 50 with drag forces induced by gas flow into the openings 50. A gas drag velocity of greater than about 15 m/s, desirably 20 m/s is sufficient.

A plurality of discrete passages (e.g. around forty (40), such as thirty-six), which may be in the form of needles, each with a width (e.g., diameter) of 1 mm and separated by 3.9 mm may be effective to pin a meniscus. The total gas flow in such a system is of the order of 100 1/min.

Further details of the openings 50 and the liquid handling structure 12 can be found in United States Patent Application Publication No. US 2008/0212046 and United States Patent Application No. US 61/071,621, filed on 8 May 2008, which are hereby incorporated by reference in their entirety.

In an embodiment formed in the undersurface 40 is one or more further (supply) openings 70 which are configured to outlet fluid (e.g. liquid, such as immersion liquid) from the liquid handling structure 12. The further opening 70 may be considered as inletting liquid into the space 11. The opening 70 is connected to passageway 75. The opening 70 is radially inwardly, with respect to the optical axis of the projection system PS, of the extraction openings 50. The liquid exiting the opening 70 of the fluid handling system 12 is directed towards the substrate W. This type of opening 70 is provided in order to reduce the chances of bubbles being generated in the immersion liquid. Gas may become trapped in a gap between the edge of the substrate W and the substrate table WT. At an advancing part of the undersurface of the liquid handling structure 12, the liquid handling structure 12 may be moving sufficiently fast relative to the facing surface of the substrate W such that liquid is unable to flow from the space 11 to the openings 50. A portion of the undersurface of the liquid handling structure 12 between the edge 20 and the openings 50 may become de-wetted, affecting the effectiveness of the meniscus pinning of the openings 50. Supplying liquid through the further opening 70, desirably near the openings 50, thereby helps reduce the risk of bubble inclusion and/or de-wetting.

The geometry of the opening 70 has an impact upon the effectiveness of the liquid handling structure 12 in containing liquid.

It is desirable that the opening 70 has a shape, in plan which is cornered, like the shape of the openings 50, in plan. Indeed, the cornered shapes of the opening 70 and openings 50 are desirably substantially similar. In an embodiment, each shape has, at the apex of each corner an opening 70 or opening 50. Desirably the opening 70 is within 10 mm, desirably 5 mm of an opening 50. Where there are a plurality of openings 70, each opening 70 is within 10 mm, desirably 5 mm of an opening 50. That is, all parts of the shape made by the openings 50 are within 10 mm of a part of the shape made by the opening 70.

Further details regarding the openings 50 and opening 70 may be found in United States Patent Application No. US 12/436,626 filed 6 May 2009 which is hereby incorporated by reference in its entirety.

An underpressure is generated between the extraction openings 50 and the facing surface for example of the substrate W or substrate table WT. (Please note reference to a facing surface includes a surface of the substrate table, the substrate W or both. References to the substrate and/or substrate table W/WT include other applicable facing surfaces, such as a sensor surface. The facing surface may be a substrate and a substrate table when, for example the undersurface 40 is located above a gap between the substrate table WT and substrate W). The closer the undersurface 40 is to the facing surface, the stronger is the flow of gas 100 and thereby the better the pinning of the meniscus 90 in position. The greater the underpressure between the extraction opening 50 and the facing surface, the greater the gas flow 100 and thereby the more stable the position of the meniscus 90. The underpressure between the opening 50 and the facing surface results in an attractive force of the liquid handling structure 12 towards the facing surface.

The flow of liquid out of the supply opening 70 results in a repulsive force between the substrate W and/or substrate table WT and the liquid handling structure 12.

For a normal separation between the liquid handling structure 12 and the substrate W and/or substrate table WT, the total force (the sum of the attractive force from extraction opening 50, the repulsive force from the supply opening 70 and gravity) is an attractive force. The stiffness of the liquid handling structure 12 (for example in the z direction, which may be the direction of the optical axis of the projection system PS and/or in a direction generally perpendicular to the surface of the substrate) represents how the force level changes with variations in distance between the liquid handling structure 12 and the substrate W and/or substrate table WT. Therefore in, an embodiment, stiffness is the derivative of total force on the y axis versus distance between the undersurface 40 of the liquid handling structure 12 and the substrate and/or substrate table WT along the x axis. In an embodiment the x and y axes may be in a plane parallel to the undersurface of the fluid handling structure. The x and y axes may be in a plane generally parallel to the surface of the substrate.

If the stiffness of the liquid handling structure 12 is too high at typical operating distances from the substrate W and/or substrate table WT this can result in a focusing error. This is because there is often a position error in the height of the liquid handling structure 12 above the substrate W and/or substrate table WT. Any variation from the desired height results in a difference in force with respect to the nominal (and calibrated) value. This difference in force leads to a displacement of the substrate W from the expected position and thereby a focusing error.

The undersurface 40 between the opening 50 and an outer edge 45 can be seen as a damper 47. The larger the damper 47 (i.e. the wider it is in the dimension between the opening 50 and the edge 45) the higher the stiffness of the liquid handling structure 12. Therefore, it is desirable to minimize the width of the damper 47.

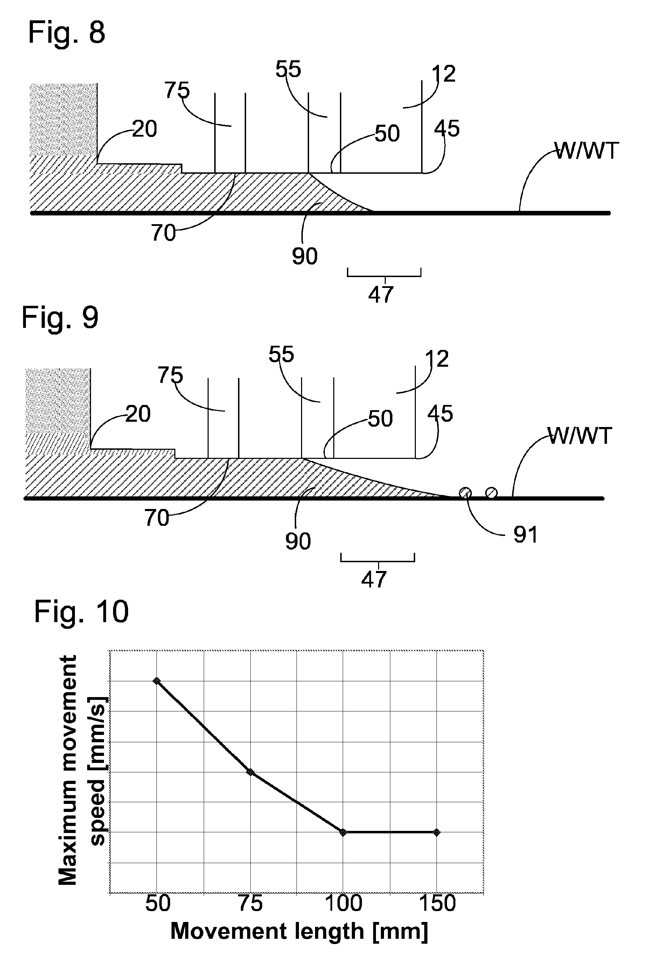

Figures 8 and 9 show how the position of the meniscus 90 changes as the substrate and/or substrate table W/WT moves to the right, as illustrated. If the relative speed of movement of the substrate and/or substrate table W/WT relative to the liquid handling structure 12 is above a critical level, the position relative to the liquid handling structure 12 where the meniscus 90 is in contact with the substrate and/or substrate table W/WT moves to the right of the Figure, away from the space 11. So the meniscus moves at a slower speed than the movement of the substrate and/or substrate table W/WT relative to the liquid handling structure 12. The position where the meniscus 90 contacts the substrate and/or substrate table W/WT moves relative to the liquid handling structure 12. As is illustrated in Figures 8 and 9, with time the position of contact of the meniscus 90 with the substrate and/or substrate table W/WT relative to the liquid handling structure 12 moves to the right of the figure, away from the space 11.

For a liquid handling structure 12 which comprises a damper 47 the meniscus 90 remains stable until the position at which it contacts the substrate and/or substrate table W/WT is no longer under the damper 47. This situation is illustrated in Figure 9. Once the meniscus 90 has reached that position it will split into droplets 91 and these are then lost by the liquid handling structure 12.

Therefore, it can be seen that it is advantageous from a liquid containment point of view to have the damper 47 as wide as possible. However, this conflicts with the desire to decrease the stiffness of the liquid handling structure 12 which leads to a smaller dimensioned damper 47 as described above.

Droplets 91 are a defectivity source, for example they can lead to contamination, a drying stain, and/or localized thermal load and they create the risk of bubble inclusion in the space on contact with the meniscus 90 extending between the liquid handling system 12 and the substrate and/or substrate table W/WT. The position of the droplet 91 on the substrate and/or substrate table W/WT may pass under the liquid confinement structure 12. A defectivity problem may be caused by the collision of the droplet 91 with the confined liquid.

For example, in a confined immersion system, the droplet 91 may collide with the liquid meniscus 90 which extends between the liquid confinement structure 12 and the substrate W. Such a collision may cause liquid to enclose gas (e.g., air) as a bubble, which may be, for example, 5-10 µm in diameter but may be 1-500 µm in diameter. The bubble size may be typically between 5 and 10 microns. The bubble may move through the immersion liquid into the space 11 between the projection system PS and the substrate W or the bubble may be stationary on the substrate W and be moved into the space 11 by relative motion of the substrate W relative to the space 11. A bubble present at this location may affect imaging, i.e. the bubble may be exposed into the resist causing an imaging defect.

The meniscus 90 reverts back to the position illustrated in Figure 7 when the direction of travel of the substrate and/or substrate table W/WT changes, for example moves in the opposite direction.

As will be appreciated, for a given relative speed of substrate and/or substrate table W/WT relative to the liquid handling structure 12, the position at which the meniscus 90 contacts the substrate and/or substrate table WT relative to the liquid handling structure 12 will change at a given rate. If the relative speed of the substrate and/or substrate table W/WT relative to the liquid handling structure 12 increases, the given rate will also increase. If the relative speed of the substrate and/or substrate table W/WT relative to the liquid handling structure 12 decreases, the given rate will also decrease. Below a certain speed of the substrate and/or substrate table W/WT relative to the liquid handling structure 12, the position at which the meniscus 90 touches the substrate and/or substrate table WT relative to the liquid handling structure 12 will remain substantially constant. This speed is termed the sub-critical speed.

On the basis of this understanding, it can be seen that for a short movement of the substrate and/or substrate table W/WT to the right it is possible to use a higher velocity relative to the liquid handling structure 12 than for a long movement. This is because for a short movement, the position at which the meniscus 90 contacts the substrate and/or substrate table WT can move fast because it only does so for a short time. In this short time the position of contact of the meniscus on the substrate and/or substrate table W/WT relative to the liquid handling structure 12 does not move from under the damper 47. Conversely, if the same velocity were used for a longer amount of time (because the distance to be travelled is greater) then spilling (i.e. a droplet may escape from the meniscus) would occur because the end of the meniscus 90 contacting with the substrate and/or substrate table W/WT would move out from under the damper 47. Therefore, for longer movements in a given direction it is desirable to reduce the speed of the substrate and/or substrate table W/WT relative to the liquid handling structure 12.

Figure 10 plots the relationship between movement length in a certain direction and maximum movement speed which is allowable before spilling occurs (i.e. before the position of the meniscus 90 on the substrate and/or substrate table W/WT moves out from under the damper 47). As can be seen, for short movement lengths, a high maximum speed can be achieved. For longer movement lengths a lower movement speed is desired. For very long lengths a maximum speed at which the position of the meniscus 90 on the substrate and/or substrate table W/WT relative to the liquid handling structure 12 does not substantially vary can be used. This speed is at the sub-critical speed.

For a liquid handling structure 12 which is symmetrical around the optical axis, a single graph such as that illustrated in Figure 10 can be used to determine the maximum speed for movement of a particular distance in any direction. However, for an un-symmetrical liquid handling system such as that illustrated in Figure 6, the characteristics may be different for different directions. In that case it may be necessary to generate data such as that illustrated in Figure 10 for a plurality of different directions. For example where the fluid confinement structure has a rectilinear shape with a corner aligned with a particular direction of motion, e.g. in scanning and/or stepping directions.

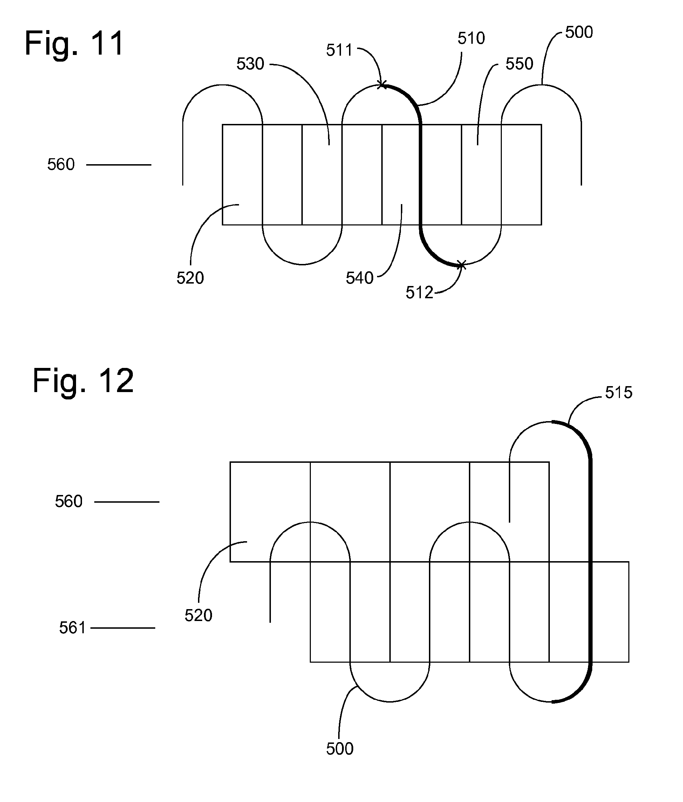

In an embodiment a controller 150 is provided for controlling movement of the substrate and/or substrate table W/WT under the liquid handling structure 12. The controller 150 controls the relative movement between the liquid handling structure 12 and the substrate and/or substrate table W/WT along a path 500. The path 500 is designed such that all of the areas of the substrate and/or substrate table W/WT which need to be illuminated by the beam B pass under the projection system PS (and thereby under the liquid handling system 12). In such a path 500 there are typically many changes in direction and some portions of which are straight. Typical paths 500 are shown in Figures 11-16 described below.

Controller 150 may vary the relative speed between the liquid handling structure 12 and the substrate and/or substrate table W/WT based on a distance between changes in direction in the path 500. Thus, for a movement in a particular direction, a graph such as that illustrated in Figure 10 is consulted. Based on a length on the x axis which is equal to a distance between changes in direction in the path 500, a maximum allowable relative speed between the substrate and/or substrate table W/WT and liquid handling structure 12 can be estimated. Thus, for that portion of the path 500, the substrate and/or substrate table W/WT is moved at that maximum allowable speed relative to the liquid handling structure 12.

The path 500 may be split into a number of portions. For each of those portions a maximum allowable speed may be calculated as described above. The controller 150 may then control the substrate and/or substrate table W/WT to travel at that speed relative to the liquid handling structure 12 for that portion.

The controller 150 may be pre-programmed with the desired path and/or speeds of motion for the desired path. That is, the calculation as to the maximum allowable speed for each portion may be made outside of the controller (for example on a separate computer or in a separate part of the immersion apparatus). The controller 150 may be programmed with the calculated data in order to control the motion between the facing surface and the liquid handling structure 12, accordingly.

For an asymmetrical liquid handling structure 12 it is desirable to vary the speed of motion based on the direction of movement of the substrate and/or substrate table W/WT relative to the liquid handling structure 12. However, that need not be the case and a generic graph such that as illustrated in Figure 10 may be developed which is valid for movement in any direction, or at least one or more particular directions. The one or more particular directions may be in the scanning and/or stepping directions. The liquid handling structure 12 may have a rectilinear shape in plan. One or more corners of the shape may be aligned with the scanning and/or stepping directions. However, that will not result in as fast a movement as is achievable if a graph such as that illustrated in Figure 10 is made for a plurality of different directions. For example, for a liquid handling structure with a rectilinear shape, a direction of movement is aligned between two adjacent corners of the shape.

The controller 150 may calculate the maximum allowable speed based on look-up tables, on a formula (such as a regression formula) or may be pre-programmed with the maximum allowable speeds for each part of the path 500.

The maximum allowable speed is also highly dependent upon the contact angle which immersion liquid makes with the facing surface (e.g., the top surface of the substrate W). Therefore, the controller 150 may vary the speed based on the contact angle which the immersion liquid makes with the facing surface.

In an embodiment the controller 150 only varies the speed in accordance with what is mentioned above when an area of facing surface (e.g., the surface of the substrate and/or substrate table W/WT) under the liquid handling structure 12 is smooth. The facing surface under the liquid handling structure 12 may be continuous. There may be no gaps or substantial changes in height in the facing surface under the liquid handling structure 12. (This may ignore the changes in height of features on the substrate formed by previous lithographic exposures). For example, the condition may be that the gap between the edge of the substrate W and the edge of the recess in the substrate table WT in which the substrate W is placed is not under the liquid handling structure 12. The gap may be positioned away from the undersurface of the liquid handling structure 12. The presence of such a gap or change in height (e.g. height step or surface discontinuity) may mean that the maximum achievable speed without leaking illustrated in, e.g., Figure 10 is not actually achievable. Therefore, the controller 150 may override control of speed of motion and use a different algorithm to control the apparatus such as an algorithm disclosed in U.S. Patent Application No. US 61/187,496 filed on 16 June 2009, which is hereby incorporated in its entirety by reference. The controller 150 may require a further condition to be met for it to vary speed of motion of the substrate table WT relative to the liquid handling structure 12 based on the distance between changes in direction in the path 500. A smooth and/or continuous surface of the substrate and/or substrate table W/WT exists, for example, in the center of the substrate W.

Figure 11 illustrates a practical example of how the controller 150 controls the speed of motion in a portion 510 of a path 500 of the substrate and/or substrate table W/WT under the liquid handling structure 12. The path 500 meanders such that fields 520, 530, 540, 550 pass sequentially under the liquid handling structure 12. The fields are imaged from the top down in Figure 11 (in the case of fields 520 and 540) or from bottom up in Figure 11 (in the case of fields 530 and 550). Thus, the movement of each field 520, 530, 540, 550 is substantially straight during imaging. The path 500 turns through 180° between each field 520, 530, 540, 550.

At the end of each portion 510 there is a change in direction. The distance may be measured in any of a number of ways. In an embodiment the distance between changes in direction in the path is calculated as the distance between two points 511, 512 at the ends of the portion 510. In an embodiment, the distance travelled may be considered to be the length of linear movement of the substrate and/or substrate table relative to the liquid handling structure 12.

The end points 511, 512 may be regarded as positions in the path 500 where the direction of motion falls outside a certain angular range of a certain direction. For example, the certain direction can be taken as the direction of the straight part of portion 510 crossing field 540. If the certain angular range is then taken as 90°, the ends are defined as being at positions 511 and 512. The distance may then be measured as any one of: along the path 500 between the ends 511, 512; in a straight line between ends 511, 512; the distance in the direction of the straight part between the ends 511, 512; or the distance of the straight part over the field 540, for example.

Figure 12 shows part of the path 500 which occurs after the motion illustrated in Figure 11. The path 500 corresponds to a movement of the substrate and/or substrate table after a row of fields 560 has been imaged and before the next row of fields 561 is to be imaged. The path is a movement between two rows. This movement comprises a long straight portion 515 which is longer than the straight portions which are over the fields 520, 530, 540, 550. Thus, the controller 150 would control the speed of the substrate and/or substrate table W/WT relative to the liquid handling structure 12 to be a slower speed because the distance of portion 515 is longer than the distance of portion 510. Thus, data such as that in Figure 10 shows that a slower speed should be used for portion 515 than portion 510. In this case the same algorithm as described above with reference to Figure 11 for measuring the distance and defining a portion could be used. The portion 515 of the path 500 in Figure 12 is longer so that the maximum speed achieved is less than that of the portion 510 of Figure 11.

Thus, the controller 150 can maximize the speed of the substrate and/or substrate table W/WT relative to the liquid handling structure 12 for each portion of the path 500. Any increase in speed results in an increase in throughput. In particular for small field sizes, an embodiment of the invention is advantageous. One or more fields can be used to make one die. A die may be a single semi-conductor device. Therefore, a user could choose for example, to form a single die from more fields than previously in order to take advantage of an embodiment of the invention. A field size may be selected from the range of between 1 mm x 1 mm to 30 mm x 35 mm. In an embodiment, a typical maximum field size is 26 mm x 33 mm with a lower limit of around 1 mm x 1 mm. Using an embodiment of the invention a field size in the x direction selected from 25-28 mm may be desirable and a field size in the x direction selected from 23-32 mm may achieve advantages. For the y direction, a field size selected from 10-25 mm may be desirable. In an embodiment, a field size in the y direction selected from 14-22 mm is desirable. In an embodiment a field size in the y direction of less than 13 mm provides little improvement so a field size in the y direction of greater than 13 mm is desirable. In an embodiment, for a field size of above about 22 mm in the y direction the throughput is improved above the throughput of a field size in the y direction below 13 mm. However the throughput may not vary greatly as the field size in the y direction is further increased.

For the x direction, a field size selected from the range of 24 to 31 mm may be desirable, or more desirably 25 to 30 mm. In an embodiment a field size selected from 25-28 mm in the x direction is desirable. In an embodiment the field size selected from 14-22 mm in the y direction is also desirable. Most desirably the field size in an embodiment is selected from 25.5-27 mm in the x direction and selected from 14.5-18 mm in the y direction.

Previously for a path with small die sizes, the maximum speed used would be a speed lower than or equal to the critical speed which is the speed at which droplets 91 would escape for any distance (e.g. the right hand side of Figure 10). With the present understanding that for small movements a higher maximum speed can be used (the left hand side of Figure 10), movements with short distances can be performed at a higher speed thereby increasing throughput.

In an embodiment a reduction in the time for imaging of a single substrate of about 2%, more desirably 3% or even more desirably 5% can been achieved using an embodiment of the invention.

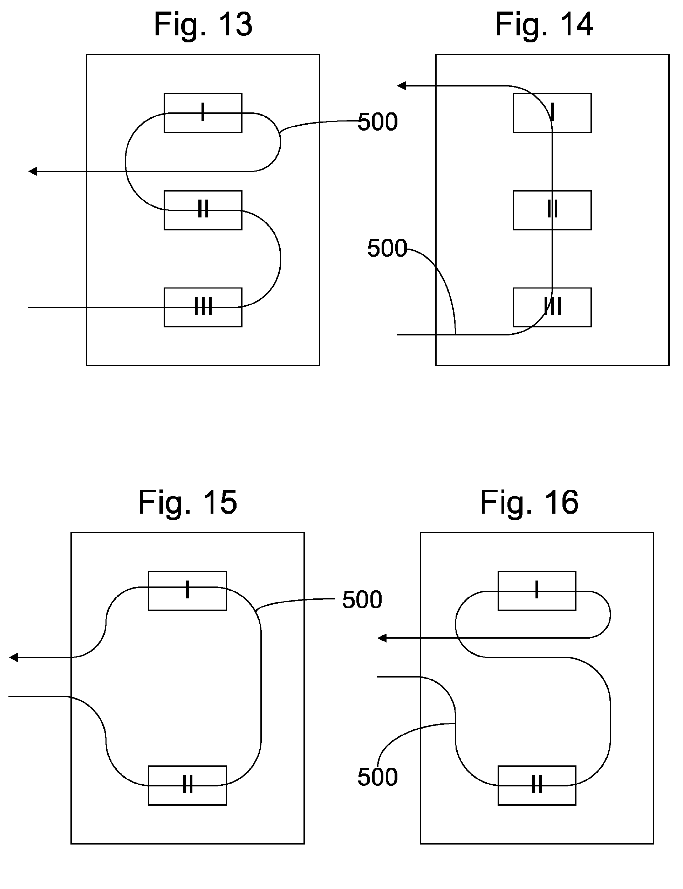

For some paths 500 there may be changes in direction which are less than 180°. For example, some paths 500 may have turns of 90°, for example such as illustrated in Figures 14 and 15. For such paths 500, the certain angular range is 45° rather than 90° as in the embodiment of Figures 11 and 12. Therefore, if the turn(s) changes the direction of movement by more than 120°, the certain angular range may be within 120-60° of the direction of the straight part, desirably 90°. If the angle through which the turn changes the direction of motion is less than 120°, then the certain angular range may be within 90-15° of the direction of the straight part, desirably 45°.

Although an embodiment of the invention has been described above with reference to the meniscus 90 extending beyond the damper 47, the meniscus may grow in length as illustrated in Figures 8 and 9 by a certain amount before leading to liquid loss for other liquid handling structures. Therefore, the principles described above are equally applicable to other types of liquid handling structure as well as ones with a damper 47 radially outwardly of extraction openings 50. An embodiment of the invention is particularly applicable to any type of liquid handling structure 12 in which the speed at which immersion liquid is lost is dependent upon a contact angle of the immersion liquid with the top surface of the substrate W.

It can be seen that an embodiment of the invention allows the relative movement speed between the liquid handling structure 12 and the substrate and/or substrate table W/WT to be at least as large as (if not greater than) the speed of the meniscus 90 on the substrate and/or substrate table WT. The speed of the meniscus 90 on the substrate and/or substrate table WT is dependent upon the contact angle of the immersion liquid to the top surface of the substrate and/or substrate table W/WT with which it is in contact. If a high receding contact angle is used, the maximum speed achievable by the meniscus 90 on the substrate and/or substrate table W/WT is increased. The speed of the meniscus 90 on the substrate and/or substrate table W/WT is also dependent upon the direction of movement relative to the liquid handling structure 12, e.g., in the case of an asymmetrical liquid handling structure 12. If the movement is aligned with the direction between the optical axis and a corner of the liquid handling structure 12 such as illustrated in Figure 6, then the maximum achievable speed is increased.

Understanding of the above mechanisms allows the path 500 of the substrate and/or substrate table W/WT under the liquid handling structure 12 to be optimized and/or the design of the liquid handling structure 12 to be optimized. For example, the path can be optimized to comprise many short steps in optimal directions thereby allowing a higher average speed even though distance of a path 500 may be increased. Thus, the path 500 can be changed and/or the speed of the substrate and/or substrate table W/WT relative to the liquid handling structure 12 can be varied throughout a path 500 according to the distance between changes in direction in the path 500.

Further, the length of the damper 47 may be varied around the periphery of the liquid handling structure 12 dependent upon the direction in which it is calculated that a low speed of movement of the substrate and/or substrate table W/WT relative to the liquid handling structure 12 needs to be used. The principle of varying the length of the damper 47 to optimize throughput is disclosed in U.S. Patent Application No. US 12/506,565 filed on 21 July 2009 which is hereby incorporated by reference in its entirety.

In one embodiment the field size of a lithographic apparatus is decreased thereby to increase throughput. This works because the distances between changes in direction in the path 500 a substrate table WT takes results in a higher allowable relative speed between the substrate table WT and the liquid handling structure 12. This may result in higher throughput.

Because of the greater positive acceleration required to achieve the higher velocity (and higher negative acceleration needed to reduce the velocity) there is a die size after which further reduction does not reduce the distance between changes in direction in the path. This is because the distances in the path required for the acceleration increases as speed increases. Therefore it is desirable that the die size is at least 23 mm in the x direction and at least 13 mm in the y direction. Desirably the field size is less than 33 mm in the x direction.

An understanding of how the motion of the substrate table WT relative to the liquid handling structure 12 may have its speed varied depending on the distance between changes in direction allows choosing of a path of the substrate table WT under liquid handling structure 12 for fastest throughput as well as for design of the apparatus.

Figures 13 and 14 each show three features I, II, III on a substrate table WT which need to be imaged. Figure 13 illustrates a path 500 for imaging each of those areas which is longer than the path 500 of Figure 14 for imaging each of the areas. However, the time taken for imaging of all three areas using the path 500 in Figure 13 is shorter than the time for imaging of all three areas using the path 500 in Figure 14. This is because there are fewer long movements in a single direction compared to the path of Figure 14. Put another way, the distances between changes in direction in the path 500 of Figure 13 are smaller and therefore allow a faster relative speed between the substrate table WT and liquid handling structure 12 than is the case with Figure 14.

In order to design a suitable path, it is necessary first to determine areas of the substrate table WT which must pass under the liquid handling structure 12, e.g., in order for illumination by the beam B to take place. It may be that one or more of those areas require the movement of that area under the liquid handling structure 12 to be in a particular direction (e.g., in order for illumination by beam B). A plurality of different paths can then be determined. The paths pass between the areas of interest and pass over each of the areas in one of the possible directions. This step could determine, for example, the paths of Figures 13 and 14. A total time taken for each of the paths to be completed is then calculable. The calculation is based on the maximum allowable speed of movement determined based on a distance between changes in direction in the path. In the case of Figure 13 although the path is longer, the higher number of changes in direction in the path allow higher to speeds to be achieved without leaking of immersion liquid from the liquid handling structure 12. Thus, it might be calculated, for example, that the path of Figure 13 actually takes less time to traverse than the path of Figure 14. On the basis of the total time calculated for each of the paths to be traversed, one of the plurality of possible paths is chosen.

Figures 15 and 16 are similar to Figures 13 and 14 in that they show two alternative paths 500 for the substrate table WT under the liquid handling structure 12. In the example of Figures 15 and 16 only two areas I, II which need to pass under the liquid handling structure 12 (for example to be illuminated by the beam B) are illustrated. However, the position at which the substrate table leaves the position under the liquid handling structure 12 is the same at which it arrives (contrary to the example of Figures 13 and 14). This may be necessary, for example, because of the design of the apparatus (for example the position of a swap bridge which allows tables to be swapped (for example between a substrate table and another substrate table or a substrate table and a measurement table)) under the liquid handling structure 12 without ceasing operation of the liquid handling system. In stopping operation of the liquid handling system, for example, in a non-limiting list, the supply of immersion liquid to the space may be stopped, the gas supply to a gas knife (if present) may be stopped, or the space 11 may be drained of liquid.

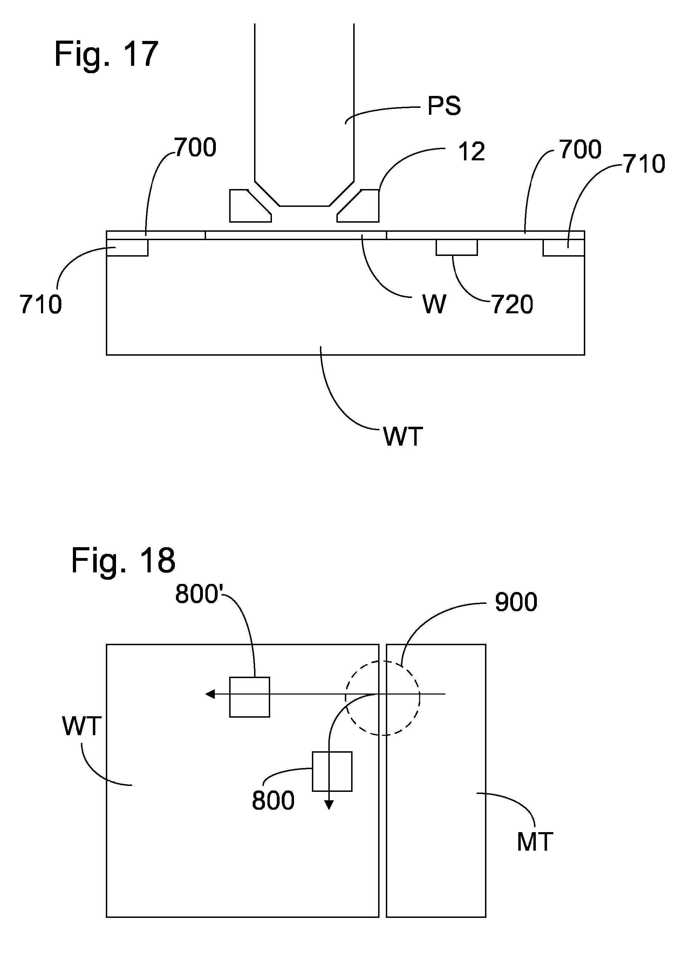

As described above, an embodiment of the invention relates varying speed of motion of the substrate table WT relative to the liquid handling structure 12 based on a distance between changes in direction in the path 500 of the substrate table WT under the liquid handling structure 12. This algorithm is used where the substrate table WT under the liquid handling structure 12 is smooth. Therefore, in one embodiment a cover plate 700 is used to cover the substrate table WT to provide a smooth surface. As illustrated in Figure 17 the cover plate 700 may cover the substrate table WT and an encoder grid 710 positioned at a radially outward edge of the substrate table WT (i.e. around a periphery of the substrate table WT). The encoder grid 710 is used in a positioning system to measure the position of the substrate table WT relative to the projection system PS. The positioning system comprises a transmitter and a receiver. The transmitter may be for transmitting a beam onto the encoder grid 710. The receiver may for receiving the reflected beam to determine the relative position of the grid relative to the transmitter and/or the receiver. The position of the transmitter and/or receiver relative to the projection system PS may be known.

In another embodiment the transmitter/receiver may be mounted to the substrate table WT and the encoder grid mounted above or below the substrate table WT, in a known fixed position relative to the projection system PS.

The cover plate 700 may cover any sensor 720 mounted on the substrate table WT. In one embodiment the cover plate 700 has a through opening in it in which the substrate W is placed.

Figure 18 illustrates a further embodiment in which the table under the liquid handling structure 12 is changed. A measurement table MT (or alternatively a substrate table WT) is moved out from under the liquid handling structure 12 and is replaced by a substrate table WT. When the substrate table WT first moves under the liquid handling structure 12, a sensor 800, for example an alignment sensor 800, is illuminated by a beam of radiation (e.g., beam B). If the apparatus is designed such that the liquid handling structure 12 must pass over area 900 when the tables swap under the liquid handling structure 12 (for example because of the positioning of a swap bridge), the positioning of the sensor 800 and the path to arrive at the sensor 800 can be varied in order to optimize throughput. Thus, it may be that the sensor 800 rather than the sensor 800' is desirable because the path to sensor 800 has more turns and a distance of the path in a given direction is shorter. For the path illustrated in Figure 18, it may be that in region 900 a speed limiting algorithm is applied such as described in U.S. Patent Application No. US 61/187,496 filed on 16 June 2009. The algorithm of an embodiment of the invention may be applied in other areas.

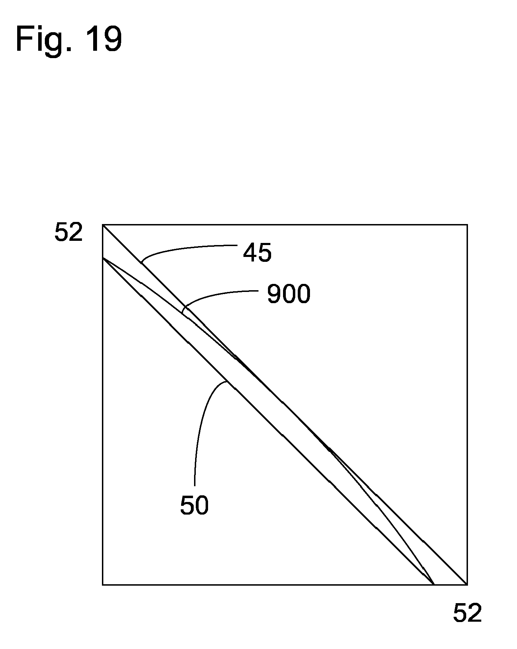

The above understanding may be applied in the design of liquid handling systems similar to those described in U.S. Patent Application No. US 12/506,565 filed on 21 July 2009. Figure 19 shows a calculation of a top view of the position of the line of contact 910 between the meniscus and the substrate table WT relative to the position of the openings 50 and the edge 45 of the damper 47. As can be seen, during movement in the y direction the damper edge 45 at the position between the corners 52 is reached by the contact line first. Therefore, during design of the liquid handling structure 12 it may be desirable to make the width of the damper 47 greater between the corners 52 than elsewhere. The design is dependent upon the path chosen or at least on the direction with the longest movements. Although Figure 19 shows line of openings 50 and the edge 45 of the damper 47 as being straight, they may be curved for example with a negative or positive radius of curvature. In such an arrangement the contact line may move further in between the corners 52 than at the corners 52. It may be desirable to have increased width between the corners in such an embodiment. The straight appearance of the line of openings and the edge 45 is intended to represent arrangements in which these lines are not straight.

As will be appreciated, any of the above described features can be used with any other feature and it is not only those combinations explicitly described which are covered in this application.

In an aspect of the invention there is provided an immersion lithographic apparatus comprising: a projection system, a facing surface, a liquid handling system and a controller. The projection system is configured to direct a patterned beam of radiation onto a substrate. The facing surface comprises a table, or a substrate supported by the table, or both. The liquid handling system is configured to supply and confine immersion liquid to a space defined between the projection system and the facing surface. The controller controls motion of the table relative to the liquid handling system during movement of the table under the liquid handling system. The controller is configured to vary the speed of the motion based on a distance between changes in direction of the motion.

The controller may be configured to vary the speed of the motion also based on direction of movement of the table relative to the liquid handling system. The controller may be configured to vary the speed of the motion to a maximum allowable speed. The maximum allowable speed may be determined from a look-up table or calculated from a formula on the basis of the distance between changes in direction of the motion.

The controller may be configured to vary the speed of the motion based on a contact angle which immersion liquid makes with the substrate, the table, or both. The controller may be configured to override control of the speed of the motion based on the distance between turns in a path of the table and/or substrate under the liquid handling system when a pre-defined area of the substrate and/or table is under the liquid handling system.

The controller may be configured to vary the speed of the motion based on the distance between changes in direction of the motion only when a further condition is met. The further condition may be that the part of the table under the liquid handling system presents a smooth surface.

The controller may be pre-programmed as to what path the table and/or substrate will take under the liquid handling system and/or how to vary the speed of the motion during the path.

The distance between changes in direction of the motion may be calculated as the distance between two points at the ends of a portion of a path which ends are at positions in the path where the direction of motion falls outside of a certain angular range of a certain direction. The certain direction may be a direction of a straight portion of the path in the portion. The distance may be measured along the path in the direction of a straight portion. The distance may be the length of a straight portion. The distance may be the distance between the ends.

The certain angular range may be dependent upon the angle through which the direction of movement changes in turns at the ends of the portion. If the turns change the direction of movement by more than or equal to 120°, the certain angle may be selected from the range of 120-60°, desirably 90°. If the angle through which the turn changes the direction of motion is less than 120°, then the certain angle may be selected from the range of 90-15°, desirably 45°.

In an aspect of the invention there is provided a method of selecting a path of a table under a liquid handling structure of an immersion lithographic apparatus. The method comprises: determining, calculating and selecting. In the determining, areas of the table which must pass under the liquid handling structure are determined. In the determining, possible directions of movement of the table under the liquid handling structure are determined. In the determining, a plurality of possible paths between the areas which paths include movement over one or more areas of the table which must pass under the liquid handling structure in one of the possible directions is determined. In the calculating, the total time for each of the plurality of possible paths based on a maximum allowable speed of movement determined based on a distance between changes in direction in the path is calculated. In the selecting, one of the plurality of possible paths based on a comparison of the calculated total times is selected.

The total time for each of the plurality of possible paths may be calculated based also on direction of movement between changes in direction in the path. The maximum allowable speed may be determined from a look-up table or calculated from a formula on the basis of the distance between changes in direction in the path. The maximum allowable speed may be determined based on a contact angle which immersion liquid makes with objects under the liquid handling structure. For at least a part of the path the maximum allowable speed of movement may be determined based on a distance between changes in direction in the path only when a further condition is met. The further condition may be that: the part of the table under the liquid handling structure presents a smooth surface. The table may be moved relative to the liquid handling structure according to the selected one of the plurality of paths.

In an aspect of the invention, there is provided a computer program for selecting a path of a table under a liquid handling structure of an immersion lithographic apparatus. The computer program, which when processed by a processor, causes the processor to: determine, calculate and select. To determine, the processor determines areas of the table which must pass under the liquid handling structure. To determine, the processor determines possible directions of movement of the table under the liquid handling structure. To determine, the processor determines a plurality of possible paths between the areas which paths include movement over one or more areas of the table which must pass under the liquid handling structure in one of the possible. To calculate, the processor calculates the total time for each of the plurality of possible paths based on a maximum allowable speed of movement determined based on a distance between changes in direction in the path. To select, the processor selects one of the plurality of possible paths based on a comparison of the calculated total times.

The computer program may cause the processor to control an actuator to move the table according to the selected path relative to the liquid handling structure.

In an aspect of the invention there is a computer readable storage medium comprising one or more sequences of machine-readable instructions to cause a processor to perform a method. The method is a method of selecting a path of a table under a liquid handling structure of an immersion lithographic apparatus. The method comprises: determining, selecting and calculating. In the determining, areas of the table which must pass under the liquid handling structure are determined. In the determining, possible directions of movement of the table under the liquid handling structure are determined. In the determining, a plurality of possible paths between the areas which paths include movement over one or more areas of the table which must pass under the liquid handling structure in one of the possible directions are determined. In the calculating, the total time for each of the plurality of possible paths based on a maximum allowable speed of movement determined based on a distance between changes in direction in the path is calculated. In the selecting, one of the plurality of possible paths based on a comparison of the calculated total times is selected.

In an aspect of the invention there is provided a method of manufacturing a device using a lithographic apparatus. The method comprises: projecting and moving. In the projecting, a patterned beam of radiation is projected from a projection system through a liquid onto a substrate. In the moving, the substrate is moved relative to the projection system through a path. The speed of motion of the substrate relative to the projection system is varied based on a distance between changes in direction in the path.

In an aspect of the invention there is provided a method of manufacturing a device using a lithographic apparatus. The method comprises: confining, projecting and moving. In the confining, liquid is confined by a confinement structure in a space between a projection system and a facing surface of a table, a substrate supported by the table, or both. In the projecting, a patterned beam of radiation is projected from the projection system through liquid onto the substrate. In the moving, the facing surface is moved relative to the projection system through a path. The distance between changes in direction in the path is selected at least in part by increasing the speed of motion of the facing surface relative to the projection system towards a subcritical speed of a liquid meniscus of the liquid between the facing surface and the confinement structure.

The distance between changes in direction may be determined at least in part by the size of area of a field on the substrate to which the patterned beam of radiation is projected.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of or about 365, 248, 193, 157 or 126 nm). The term "lens", where the context allows, may refer to any one or combination of various types of optical components, including refractive and reflective optical components.

While specific embodiments of the invention have been described above, it will be appreciated that the invention may be practiced otherwise than as described. For example, the embodiments of the invention may take the form of a computer program containing one or more sequences of machine-readable instructions for executing a method as disclosed above, or a data storage medium (e.g. semiconductor memory, magnetic or optical disk) having such a computer program stored therein. Further, the machine readable instruction may be embodied in two or more computer programs. The two or more computer programs may be stored on one or more different memories and/or data storage media.

The controllers described herein may each or in combination be operable when the one or more computer programs are read by one or more computer processors located within at least one component of the lithographic apparatus. The controllers may each or in combination have any suitable configuration for receiving, processing, and sending signals. One or more processors are configured to communicate with the at least one of the controllers. For example, each controller may include one or more processors for executing the computer programs that include machine-readable instructions for the methods described above. The controllers may include data storage medium for storing such computer programs, and/or hardware to receive such medium. So the controller(s) may operate according the machine readable instructions of one or more computer programs.

One or more embodiments of the invention may be applied to any immersion lithography apparatus, in particular, but not exclusively, those types mentioned above and whether the immersion liquid is provided in the form of a bath, only on a localized surface area of the substrate, or is unconfined. In an unconfined arrangement, the immersion liquid may flow over the surface of the substrate and/or substrate table so that substantially the entire uncovered surface of the substrate table and/or substrate is wetted. In such an unconfined immersion system, the liquid supply system may not confine the immersion liquid or it may provide a proportion of immersion liquid confinement, but not substantially complete confinement of the immersion liquid.

A liquid supply system as contemplated herein should be broadly construed. In certain embodiments, it may be a mechanism or combination of structures that provides a liquid to a space between the projection system and the substrate and/or substrate table. It may comprise a combination of one or more structures, one or more fluid openings including one or more liquid openings, one or more gas openings or one or more openings for two phase flow. The openings may each be an inlet into the immersion space (or an outlet from a fluid handling structure) or an outlet out of the immersion space (or an inlet into the fluid handling structure). In an embodiment, a surface of the space may be a portion of the substrate and/or substrate table, or a surface of the space may completely cover a surface of the substrate and/or substrate table, or the space may envelop the substrate and/or substrate table. The liquid supply system may optionally further include one or more elements to control the position, quantity, quality, shape, flow rate or any other features of the liquid.

The descriptions above are intended to be illustrative, not limiting. Thus, it will be apparent to one skilled in the art that modifications may be made to the invention as described without departing from the scope of the claims set out below.

## Claims

1. An immersion lithographic apparatus comprising:
a projection system configured to direct a patterned beam of radiation onto a substrate;
a facing surface comprising a table, or a substrate supported by the table, or both;
a liquid handling system configured to supply and confine immersion liquid to a space defined between the projection system and the facing surface; and
a controller to control motion of the table relative to the liquid handling system during movement of the table under the liquid handling system, the controller configured to vary the speed of the motion based on a distance between changes in direction of the motion.

2. The immersion lithographic apparatus of claim 1, wherein the controller is configured to vary the speed of the motion also based on direction of movement of the table relative to the liquid handling system.

3. The immersion lithographic apparatus of claim 1 or claim 2, wherein the controller is configured to vary the speed of the motion to a maximum allowable speed.

4. The immersion lithographic apparatus of any of claims 1-3, wherein the controller is configured to vary the speed of the motion based on a contact angle which immersion liquid makes with the substrate, the table, or both.

5. The immersion lithographic apparatus of any of claims 1-4, wherein the controller is configured to override control of the speed of the motion based on the distance between turns in a path of the table and/or substrate under the liquid handling system when a pre-defined area of the substrate and/or table is under the liquid handling system.

6. The immersion lithographic apparatus of any of claims 1-5, wherein the controller is configured to vary the speed of the motion based on the distance between changes in direction of the motion only when a further condition is met.

7. The immersion lithographic apparatus of claim 7, wherein the further condition is that the part of the table under the liquid handling system presents a smooth surface.

8. The immersion lithographic apparatus of any of claims 1-7, wherein the controller is pre-programmed as to what path the table and/or substrate will take under the liquid handling system and/or how to vary the speed of the motion during the path.

9. The immersion lithographic apparatus of any of claims 1-7, wherein the distance between changes in direction of the motion is calculated as the distance between two points at the ends of a portion of a path which ends are at positions in the path where the direction of motion falls outside of a certain angular range of a certain direction.

10. The immersion lithographic apparatus of claim 9, wherein the certain direction is a direction of a straight portion of the path in the portion.

11. The immersion lithographic apparatus of claim 9 or claim 10, wherein the distance is measured along the path in the direction of a straight portion, or is the length of a straight portion, or is the distance between the ends.

12. The immersion lithographic apparatus of any of claims 9-11, wherein the certain angular range is dependent upon the angle through which the direction of movement changes in turns at the ends of the portion.

13. A method of manufacturing a device using a lithographic apparatus, the method comprising:
projecting a patterned beam of radiation from a projection system through a liquid onto a substrate; and
moving the substrate relative to the projection system through a path, wherein the speed of motion of the substrate relative to the projection system is varied based on a distance between changes in direction in the path.

14. A computer program for selecting a path of a table under a liquid handling structure of an immersion lithographic apparatus, the computer program which when processed by a processor, causes the processor to implement the method of claim 13.

15. A computer readable storage medium, comprising one or more sequences of machine-readable instructions to cause a processor to perform a method of selecting a path of a table under a liquid handling structure of an immersion lithographic apparatus, the method of claim 13.
